# EUROPÄISCHE PATENTSCHRIFT

(11) **EP 0 736 419 B1**
(45) Veröffentlichungstag und Bekanntmachung des Hinweises auf die Patenterteilung: **22.12.1999**
(21) Anmeldenummer: 96104692.7
(22) Anmeldetag: 25.03.1996
(51) Int. Cl.: B60R 16/02

(54) **Einrichtung zur Bedienung zumindest eines in ein Kraftfahrzeug eingebauten Gerätes**
Device for the operation of at least one vehicle-mounted apparatus
Dispositif pour la commande d'au moins un appareil monté dans un véhicule

(30) Priorität: 06.04.1995 DE 19512896
(43) Veröffentlichungstag der Anmeldung: 09.10.1996
(73) Patentinhaber: ADAM OPEL AG, 65423 Rüsselsheim (DE)
(72) Erfinder: Kahlstatt, Michael, Dipl.-Ing., 61440 Oberursel (DE); Möschl, Matthias, Dipl.-Ing., 65439 Flörsheim (DE)
(74) Vertreter: Kümpfel, Heinz, Dipl.-Ing.

(56) Entgegenhaltungen:
- DE-A- 3 520 972
- FR-A- 2 653 279
- PATENT ABSTRACTS OF JAPAN vol. 018, no. 382 (E-1580), 19.Juli 1994 & JP 06 111669 A (FUJIKURA LTD), 22.April 1994,
- PATENT ABSTRACTS OF JAPAN vol. 018, no. 386 (M-1641), 20.Juli 1994 & JP 06 107024 A (FUJIKURA LTD), 19.April 1994,

## Beschreibung

Die Erfindung bezieht sich auf eine Einrichtung zur Bedienung zumindest eines in ein Kraftfahrzeug eingebauten Gerätes mit den im Oberbegriff des Patentanspruchs 1 angegebenen Merkmalen. Die Einrichtung beinhaltet Bedienschalter (im allgemeinen als Tastschalter ausgeführt), über die Gerätefunktionen ansteuerbar sind. Für den Fahrzeugführer ist es von Vorteil, wenn die Bedienschalter in ein Lenkrad des Kraftfahrzeugs integriert sind, da so die geringste Ablenkungsgefahr besteht. Es sollen mit einer möglichst geringen Anzahl an Steuerleitungen viele verschiedene Steuerbefehle übertragbar sein. Als anzusteuernde Geräte im Kraftfahrzeug kommen eine Hupe, eine Audiokomponente, ein Fahrerinformationssystem, Fensterheber, eine Heizungs-/Klimaanlage oder z. B. ein automatisches Getriebe neben weiteren Möglichkeiten in Betracht.

Eine derartige Einrichtung ist beispielsweise aus der DE-OS 35 20 972 bekannt. Bei einem ständig wachsendem Komfort in Kraftfahrzeugen kommt jedoch der Diagnose von Fehlern eine wachsende Bedeutung zu. Hier bietet die o. g. elektrische Anordnung nur begrenzte Möglichkeiten, so daß die Fehlersuche aufwendig ist.

Gleiches gilt für eine Schaltung ähnlicher Art nach der DE-OS 29 03 614, die hinsichtlich der ansteuerbaren Gerätefunktionen einen verbesserten Komfort gegenüber der erstgenannten Einrichtung bietet.

Es ist Aufgabe der Erfindung, eine Einrichtung der o. g. Art zu schaffen, die ohne funktionelle Einschränkungen umfassend diagnostizierbar ist, so daß nicht nur feststellbar ist, ob ein und welcher Bedienschalter betätigt ist, sondern auch Aussagen darüber abzuleiten sind, ob die Einrichtung überhaupt ordnungsgemäß an eine Steuereinheit für das Gerät angeschlossen ist oder ein Kurzschluß vorliegt. Bei erfolgter Fehlerdiagnose soll eine Fehlermeldung ausgegeben oder abgespeichert werden.

Zur Lösung dieser Aufgabe zeichnet sich die Einrichtung nach dem Oberbegriff des Patentanspruchs 1 zusätzlich durch die im Patentanspruch 1 angegebenen kennzeichnenden Merkmale aus. Weitere Merkmale der Erfindung ergeben sich aus den Patentansprüchen 2 bis 7.

Die eine elektrische Schaltung innerhalb der Einrichtung bildenden Bedienschalter und die diesen zugeordneten elektrischen Widerstände sind parallel zu einem weiteren elektrischen Widerstand geschaltet, so daß bei ordnungsgemäßem Anschluß der Einrichtung (bzw. ihrer elektrischen Schaltung) an eine Steuereinheit des anzusteuernden Gerätes auch dann ein Strom fließt, wenn keiner der Bedienschalter betätigt wird. Die elektrische Schaltung der Einrichtung ist, wie dies bekannt ist, Teil einer Spannungsteiler-Schaltung der Steuereinheit sobald die elektrische Verbindung besteht. Da nunmehr ein Strom fließt, wenn keiner der Bedienschalter betätigt ist, kann der Zustand des ordnungsgemäßen Anschlusses diagnostiziert werden.

Da eine Lenkrad-Bedien-Einrichtung optional in ein Kraftfahrzeug eingebaut werden kann, ist es bisher notwendig gewesen, der Steuereinheit eine entsprechende Spezifikation zu geben. Nunmehr erkennt sie selbsttätig, ob eine solche Einrichtung angeschlossen ist oder nicht, da unterschiedliche Signalwerte am Steuergeräte-Eingang anliegen. Des weiteren werden eventuell vorhandene Anschlußfehler wie Kurzschluß zur Spannung U + einer Batterie oder zur Fahrzeugmasse erkannt.

Die Bedienschalter der Einrichtung werden innerhalb der elektrischen Schaltung parallel zueinander und zu dem zusätzlichen Widerstand angeordnet. Die den Bedienschaltern zugeordneten Widerstände sind derart (voneinander verschieden) bemessen, daß je nachdem welcher Schalter betätigt wird, ein unterschiedlicher Spannungsabfall zu registrieren ist. Die elektrische Schaltung der Einrichtung ist Bestandteil eines Spannungsteilers, wobei Signalspannungen, die aus der Konfiguration des Spannungsteilers resultieren, der Steuereinheit zugeführt werden. Über eine Zuschaltung verschiedener Widerstände durch Bedienung der Bedienschalter wird ein Zweig des Spannungsteilers verändert und bestimmt damit die Konfiguration des Spannungsteilers. Die Widerstände können einerseits in Reihe zu jeweils einem Bedienschalter geschaltet werden. Andererseits ist es möglich, die Widerstände jeweils vor einem Bedienschalterzweig anzuordnen, wobei die den einzelnen Schaltern zugeordneten Widerstände dann in Reihe zueinander geschaltet sind.

Eine detailliertere Beschreibung der Erfindung erfolgt anhand zweier Ausführungsbeispiele, wobei dargestellt ist in
- Fig. 1:: eine Einrichtung nach der Erfindung bei in Reihe zu Bedienschaltern angeordneten elektrischen Widerständen in schematischer Darstellungsweise;
- Fig. 2:: eine Einrichtung nach der Erfindung bei in Reihe zueinander angeordneten elektrischen Widerständen in ebenfalls schematischer Darstellungsweise.

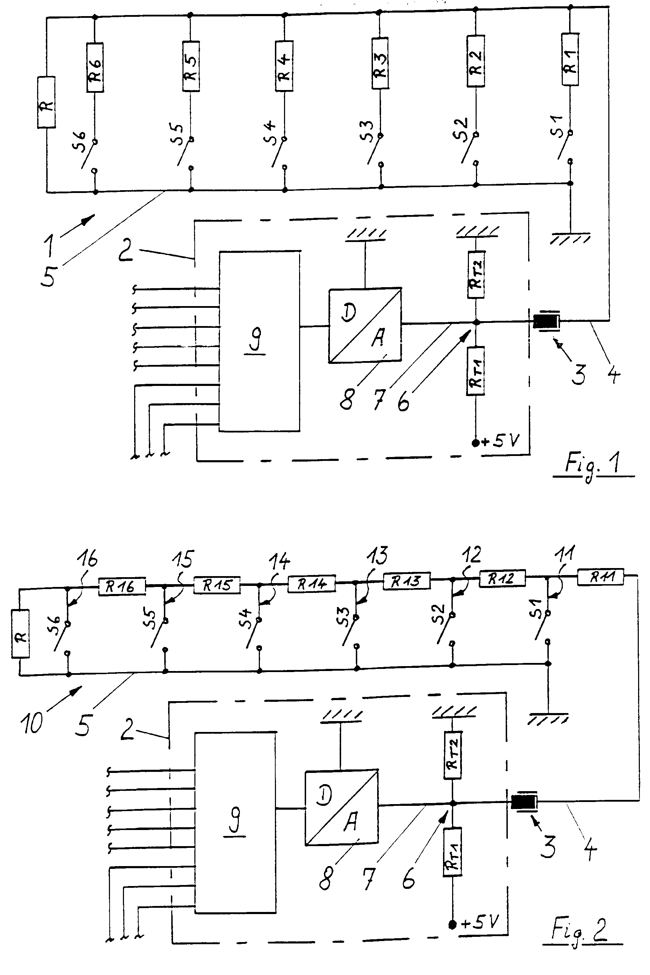

In Figur 1 ist eine Einrichtung 1 nach der Erfindung in Verbindung mit einer Steuereinheit 2 gezeigt. Eine elektrische Verbindung zwischen der Einrichtung 1 und der Steuereinheit 2 besteht über einen elektrischen Kontakt 3, der als Schleifringkontakt oder als Steckkontakt ausgeführt sein kann. Die Einrichtung 1 ist beispielsweise in ein Lenkrad eines Kraftfahrzeuges integriert und dient in Verbindung mit der Steuereinheit 2 zumindest zur Bedienung einer Audiokomponente und eventuell auch zusätzlich eines weiteren Gerätes. Mit Hilfe der gezeigten Anordnung ist es möglich, bestimmte Gerätefunktionen vom Lenkrad aus zu aktivieren, ohne daß viele Steuerleitungen mit dem Gerät oder der Steuereinheit 2 zu kontaktieren sind.

Die Einrichtung 1 besteht aus einer Anzahl von Bedienschaltern S1 bis S6, über die die Gerätefunktionen ansteuerbar sind. Die Anzahl von Bedienschaltern (hier sechs) ist prinzipiell entsprechend den Erfordernissen frei wählbar. Jeweils ein elektrischer Widerstand R1 bis R6 ist in Reihe zu einem Bedienschalter S1 bis S6 geschaltet, und diese einzelnen Reihenschaltungen sind parallel zueinander in einer elektrischen Schaltung angeordnet. Ein weiterer Widerstand R ist parallel zu der sechsten Schalter-Widerstand-Gruppe (S6, R6) geschaltet, könnte jedoch auch an anderer Stelle der Schaltung parallel zu den Schaltern S1 bis S6 angeordnet sein. Die Schaltung wird über eine Leitung 4 mit Spannung versorgt. Mit dem Bezugszeichen 5 ist eine Masseleitung gekennzeichnet. Die Steuereinheit 2 umfaßt einen Spannungsteiler, an dem die Leitung 4 über den Kontakt 3 angeschlossen ist. Der Spannungsteiler beinhaltet zwei weitere elektrische Widerstände R_{T1} und R_{T2}, wobei der Widerstand R_{T1} mit einer Spannung von +5 V, die auch als Betriebsspannung der Steuereinheit 2 vorliegt, versorgt wird und der Widerstand R_{T2} an Masse anliegt. Von einem Knotenpunkt 6 des Spannungsteilers aus verläuft eine Leitung 7 zu einem A/D-Wandler 8 der Steuereinheit 2. Die gewandelten Signalwerte werden einem Mikroprozessor 9 zugeleitet, wo auch Steuersignale zur Aktivierung entsprechender Gerätefunktionen abgeleitet werden.

Bei nicht an die Steuereinheit 2 angeschlossener Einrichtung 1 fällt am Widerstand R_{T1} ein Teil (beispielsweise 0,2 V) der Speisespannung (+5 V) ab, und eine entsprechende Restspannung (4,8 V) ist am Knotenpunkt 6 meßbar. Wird diese Restspannung dem A/D-Wandler 8 zugeführt, leitet der Mikroprozessor 9 die eindeutige Aussage "keine Einrichtung 1 angeschlossen" ab. Schlußfolgernd können beispielsweise direkt an der Audiokomponente angeordnete Steuerelemente aktiviert werden, die sonst (bei angeschlossener Einrichtung 1) deaktiviert sind.

Nach Anschluß der Einrichtung 1 über den Kontakt 3 fließt Strom über den Widerstand R auch dann, wenn keiner der Bedienschalter S1 bis S6 betätigt ist. Eine Spannung (im Beispiel kleiner 4,8 V) wird erfaßt und gilt als Zeichen dafür, daß die Einrichtung ordnungsgemäß angeschlossen ist. Die Größe der jetzt zu erfassenden Spannung hängt von der Größe der Widerstände R_{T1} und R ab.

Bei einem Kurzschluß der Leitung 4 nach Masse ist am A/D-Wandler 8 keine Spannung erfaßbar. Ein Kurzschluß der Leitung 4 zur Batteriespannung (die im allgemeinen +12 V beträgt) hat zur Folge, daß am Knotenpunkt 6 diese Spannung anliegt. Dies ist ebenfalls über den Mikroprozessor 9 auswertbar.

Somit sind folgende Grundzustände exakt diagnostizierbar:
- Einrichtung 1 ordnungsgemäß angeschlossen (kein Bedienschalter S1 bis S6 betätigt);
- Einrichtung 1 nicht angeschlossen;
- Kurzschluß der Leitung 4 nach Masse;
- Kurzschluß der Leitung 4 zur Batteriespannung.

Im Ergebnis der Diagnose, die zu bestimmten Zeitpunkten automatisch stattfinden kann (beispielsweise beim Fahrzeugstart), können Nachrichten zur Ausgabe gebracht oder Informationen gespeichert werden. Dazu kann eine Ausgabeeinheit, wie ein Display, vom Prozessor 9 angesteuert werden oder ein elektronischer Speicher wird zum späteren Auslesen mit Informationen beschickt.

Diese exakte Diagnostizierbarkeit ist besonders vorteilhaft gegenüber dem Stand der Technik und schafft wesentliche Erleichterungen bei der Fahrzeugmontage und Instandhaltung.

Wird einer der Schalter S1 bis S6 betätigt, fließt Strom über den entsprechenden Schalterkreis und den dem jeweiligen Schalter S1 bis S6 zugeordneten Widerstand R1 bis R6. Die Widerstände R1 bis R6 sind verschieden voneinander dimensioniert, so daß die im Knotenpunkt 6 anliegende Spannung abhängig davon ist, welcher Bedienschalter S1 bis S6 betätigt wurde. Im Mikroprozessor 9 werden die gewandelten Spannungen ausgewertet und entsprechende Gerätefunktionen angesteuert. Diese Spannungen weichen von den Spannungen ab, die anliegen, wenn einer der weiter oben beschriebenen Betriebszustände vorliegt.

Auf das in Figur 2 gezeigte Ausführungsbeispiel der Erfindung sind die meisten der zum ersten Ausführungsbeispiel gemachten Aussagen übertragbar. Gleiche Bauelemente sind auch mit gleichen Bezugszeichen versehen. Die Steuereinheit 2 ist identisch aufgebaut und über den Kontakt 3 mit einer Einrichtung 10 zur Gerätebedienung verbunden. Es sind die gleichen Betriebszustände diagnostizierbar, wie im ersten Beispiel, anders ist nur die Anordnung von elektrischen Widerständen R11 bis R16, die den Bedienschaltern S1 bis S6 zugeordnet sind. Die Bedienschalter S1 bis S6 und der weitere Widerstand R sind wiederum parallel zueinander geschaltet. Vor jedem Bedienschalterzweig 11 bis 16 ist jeweils einer der Widerstände R11 bis R16 angeordnet, wobei diese Widerstände R11 bis R16 jetzt in Reihe zueinander geschaltet sind. Die Widerstände R11 bis R16 könnten alle gleich groß dimensioniert sein, aber auch unterschiedliche Widerstandswerte aufweisen. Je nachdem welcher Bedienschalter S1 bis S6 betätigt wird, wirkt eine Summe von Widerständen. Bei Betätigung des Schalters S4 wirkt beispielsweise die Summe der Widerstände R11 + R12 + R13 + R14, wobei diese dann parallel zu den Widerständen R15 + R16 + R wirken. Ist keiner der Bedienschalter S1 bis S6 betätigt, wirkt die Reihenschaltung der Widerstände R11 bis R16 und R am Knotenpunkt 6 und der Betriebszustand der Einrichtung 10 ist eindeutig erkennbar (Einrichtung 10 angeschlossen, kein Bedienschalter S11 bis S16 betätigt). Auch so sind alle Betriebszustände der Einrichtung 10 über den Mikroprozessor 9 eindeutig feststellbar.

## Patentansprüche

1. Einrichtung (1; 10) zur Bedienung zumindest eines in ein Kraftfahrzeug eingebauten Gerätes, die Bedienschalter (S1 bis S6) und den Bedienschaltern (S1 bis S6) zugeordnete elektrische Widerstände (R1 bis R6; R11 bis R16) innerhalb einer elektrischen Schaltung zur Aktivierung unterschiedlicher Gerätefunktionen umfaßt, die durch zumindest einen elektrischen Kontakt (3) mit einer Steuereinheit (2) elektrisch verbindbar und im verbundenen Zustand Bestandteil einer Spannungsteiler-Schaltung ist, wobei der Steuereinheit (2) unterschiedliche, vom aktuellen Betriebszustand der Einrichtung (1; 10) abhängige Signalwerte zugeleitet werden und die Steuereinheit (2) in Abhängigkeit von den Signalwerten die Gerätefunktionen aktiviert, **dadurch gekennzeichnet**, daß ein weiterer elektrischer Widerstand (R) parallel zu der elektrischen Schaltung der Bedienschalter (S1 bis S6) geschaltet und bei ordnungsgemäßer Verbindung zwischen der Einrichtung (1; 10) und der Steuereinheit (2) von einem Strom durchflossen ist.

2. Einrichtung (1) nach Anspruch 1, **dadurch gekennzeichnet**, daß jeder Bedienschalter (S1 bis S6) mit einem elektrischen Widerstand (R1 bis R6) in Reihe geschaltet ist und diese Reihenschaltungen sowie der weitere elektrische Widerstand (R) zueinander parallel geschaltet sind.

3. Einrichtung (10) nach Anspruch 1, **dadurch gekennzeichnet**, daß die einzelnen Bedienschalter (S1 bis S6) und der weitere elektrische Widerstand (R) parallel zueinander geschaltet sind und vor jedem Bedienschalterzweig (11 bis 16) ein dem jeweiligen Bedienschalter (S1 bis S6) zugeordneter Widerstand (R11 bis R16) angeordnet ist, derart, daß diese Widerstände (R11 bis R16) eine Reihenschaltung bilden.

4. Einrichtung nach den Ansprüchen 1 bis 3**, dadurch gekennzeichnet**, daß die elektrischen Widerstände (R1 bis R6; R11 bis R16) derart bemessen sind, daß die der Steuereinheit (2) zugeführten Signalwerte eine Unterscheidung der folgenden Ereignisse zulassen:
- Einrichtung (1; 10) ordnungsgemäß angeschlossen und kein Bedienschalter (S1 bis S6) betätigt;
- Einrichtung (1; 10) nicht angeschlossen;
- Kurzschluß einer elektrischen Leitung 4 zur Spannung U + einer Batterie;
- Kurzschluß der elektrischen Leitung 4 nach Masse;
- Einrichtung (1; 10) ordnungsgemäß angeschlossen und ein bestimmter Bedienschalter (S1 bis S6) betätigt.

5. Einrichtung (1; 10) nach den Ansprüchen 1 bis 4, **dadurch gekennzeichnet**, daß in Abhängigkeit von dem aktuellen Betriebszustand der Einrichtung (1; 10) durch die Steuereinheit (2) Gerätefunktionen aktiviert oder Fehlermeldungen an eine Ausgabeeinheit ausgegeben bzw. in einem Speicher abgespeichert werden.

6. Einrichtung (1; 10) nach den Ansprüchen 1 bis 5, **dadurch gekennzeichnet**, daß die über die Bedienschalter (S1 bis S6) und die Steuereinheit (2) anzusteuernden Geräte des Kraftfahrzeugs als Hupe und/oder als Audiokomponente und/oder als Fahrerinformationssystem und/ oder als Fensterheber und/oder als Heizungs-/Klimaanlage und/oder als automatisches Getriebe ausgebildet sind, wobei an sich bekannte Gerätefunktionen aktivierbar sind.

7. Einrichtung (1; 10) nach den Ansprüchen 1 bis 6, **dadurch gekennzeichnet**, daß zumindest die Bedienschalter (S1 bis S6) in ein Lenkrad des Kraftfahrzeugs integriert sind.

## Claims

1. System (1; 10) for the operation of at least one item of equipment fitted in a motor vehicle, which includes control switches (S1 to S6) and electrical resistors (R1 to R6; R11 to R16) associated with the control switches (S1 to S6) within an electrical circuit for the activation of different equipment functions, and which can be electrically connected to a control unit (2) by at least one electrical contact (3) and in the connected state forms part of a voltage divider circuit, wherein different signal values depending on the current operative state of the system (1; 10) are fed to the control unit (2) and the control unit (2) activates the equipment functions as a function of the signal values, characterised in that an additional electrical resistor (R) is connected in parallel with the electrical circuit of the control switches (S1 to S6) and has a current flowing through it when there is proper connection between the system (1; 10) and the control unit (2).

2. System (1) according to claim 1, characterised in that each control switch (S1 to S6) is connected in series with an electrical resistor (R1 to R6), and these series circuits and the additional electrical resistor (R) are connected in parallel with each other.

3. System (10) according to claim 1, characterised in that the individual control switches (S1 to S6) and the additional electrical resistor (R) are connected in parallel with each other, and in front of each control switch branch (11 to 16) is arranged a resistor (R11 to R16) associated with the respective control switch (S1 to S6), such that these resistors (R11 to R16) form a series circuit.

4. System according to claims 1 to 3, characterised in that the electrical resistors (R1 to R6; R11 to R16) have dimensions such that the signal values fed to the control unit (2) allow the following events to be distinguished:
- system (1; 10) properly connected and no control switch (S1 to S6) operated;
- system (1; 10) not connected;
- short circuit of an electrical wire 4 to the voltage U + of a battery;
- short circuit of the electrical wire 4 to earth;
- system (1; 10) properly connected and a given control switch (S1 to S6) operated.

5. System (1; 10) according to claims 1 to 4, characterised in that, depending on the current operative state of the system (1; 10), equipment functions are activated by the control unit (2) or error messages are outputted to an output unit or stored in a memory.

6. System (1; 10) according to claims 1 to 5, characterised in that the items of equipment of the motor vehicle to be driven by the control switches (S1 to S6) and the control unit (2) are constructed as a horn and/or as an audio component and/or as a driver information system and/or as a window winder and/or as a heating/air conditioning system and/or as an automatic transmission, wherein equipment functions known in the art can be activated.

7. System (1; 10) according to claims 1 to 6, characterised in that at least the control switches (S1 to S6) are integrated in a steering wheel of the motor vehicle.

## Revendications

1. Dispositif (1; 10) pour la commande d'au moins un appareil monté dans un véhicule automobile, qui comprend des commutateurs de commande (S1 à S6) et des résistances électriques (R1 à R6; R11 à R16) associées aux commutateurs (S1 à S6) à l'intérieur d'un circuit électrique pour activer diverses fonctions de l'appareil, qui peut être relié électriquement à une unité de commande (2) par au moins un contact électrique (3) et qui, à l'état connecté, fait partie d'un circuit diviseur de tension, des valeurs de signal différentes, dépendantes de l'état de fonctionnement actuel du dispositif (1; 10) étant transmises à l'unité de commande (2) et l'unité de commande activant les fonctions de l'appareil en relation avec les valeurs de signal, caractérisé par le fait qu'une résistance électrique (R) supplémentaire est branchée en parallèle avec le circuit électrique des commutateurs de commande (S1 à S6) et que ladite résistance est traversée par un courant lorsque la liaison entre le dispositif (1; 10) et l'unité de commande (2) est correctement établie.

2. Dispositif (1) selon la revendication 1, caractérisé par le fait que chaque commutateur de commande (S1 à S6) est branché en série avec une résistance électrique (R1 à R6) et que ces circuits série et la résistance électrique supplémentaire (R) sont branchés en parallèle les uns avec les autres.

3. Dispositif (10) selon la revendication 1, caractérisé par le fait que les différents commutateurs de commande (S1 à S6) et la résistance électrique supplémentaire (R) sont branchés en parallèle les uns avec les autres et qu'une résistance (R11 à R16) associée au commutateur de commande (S1 à S6) concerné est placée de vant chaque branche de commutateur de commande (11 à 16), de telle sorte que lesdites résistances (R11 à R16) forment un circuit série.

4. Dispositif selon les revendications 1 à 3, caractérisé par le fait que les résistances électriques (R1 à R6; R11 à R16) sont calculées de telle sorte que les valeurs de signal transmises à l'unité de commande (2) permettent de distinguer les évènements suivants:
- dispositif (1; 10) connecté correctement et aucun commutateur de commande (S1 à S6) actionné
- dispositif (1; 10) non connecté;
- court-circuit d'une ligne électrique 4 avec la tension U+ d'une batterie;
- court-circuit de la ligne électrique 4 avec la masse; dispositif (1; 10) connecté correctement et un commutateur de commande donné (S1 à S6) actionné.

5. Dispositif (1; 10) selon les revendications 1 à 4, caractérisé par le fait qu'en fonction de l'état de fonctionnement actuel du dispositif (1; 10), des fonctions de l'appareil sont activées par l'unité de commande (2) ou des messages de défaut sont transmises à une une unité de sortie ou sont mémorisées dans une mémoire.

6. Dispositif (1; 10) selon les revendications 1 à 5, caractérisé par le fait que les appareils du véhicule à commander par l'intermédiaire des commutateurs de commande (S1 à S6) et de l'unité de commande (2) se présentent sous la forme de klaxon et/ou de composants audio et/ou de systèmes d'information du conducteur et/ou de lève-vitre et/ou d'installation de chauffage/climatisation et/ou de boîte de vitesse automatique, des fonctions d'appareils connues en elles-mêmes étant activées.

7. Dispositif (1; 10) selon les revendications 1 à 6, caractérisé par le fait qu'au moins les commutateurs de commande (S1 à S6) sont intégrés dans un volant du véhicule automobile.
